# EUROPÄISCHE PATENTSCHRIFT

(11) **EP 0 596 294 B1**
(45) Veröffentlichungstag und Bekanntmachung des Hinweises auf die Patenterteilung: **09.06.1999**
(21) Anmeldenummer: 93116613.6
(22) Anmeldetag: 14.10.1993
(51) Int. Cl.: G03F 7/004, C07C 309/73

(54) **Positiv arbeitendes strahlungsempfindliches Gemisch und damit hergestelltes Aufzeichnungsmaterial**
Positive-working radiation-sensitive mixture and recording material produced therewith
Composition sensible aux rayonnements à effet positif et matériel d'enregistrement produit de cette composition

(30) Priorität: 26.10.1992 DE 4236068
(43) Veröffentlichungstag der Anmeldung: 11.05.1994
(73) Patentinhaber: Clariant GmbH, 65929 Frankfurt am Main (DE)
(72) Erfinder: Röschert, Horst, Dr., D-55437 Ober-Hilbersheim (DE); Pawlowski, Georg, Dr., D-65187 Wiesbaden (DE); Spiess, Walter, Dr., D-64807 Dieburg (DE); Wengenroth, Horst, Dr., D-56457 Westerburg (DE)

(56) Entgegenhaltungen:
- EP-A- 0 508 174
- US-A- 4 510 290
- US-A- 4 618 564
- US-A- 4 636 575
- US-A- 4 708 926
- A. KNOP ET AL. 'Penolic Resins' 1985 , SPRINGER-VERLAG , BERLIN, HEIDELBERG, NEW YORK, TOKYO

## Beschreibung

Die Erfindung betrifft ein positiv arbeitendes strahlungsempfindliches Gemisch, das
a) einen α-Hydroxymethyl-benzoin-sulfonsäureester, der unter der Einwirkung aktinischer Strahlung starke Säure bildet, und
b) ein in Wasser unlösliches, in wäßrig-alkalischen Lösungen dagegen lösliches, zumindest quellbares Bindemittel enthält,
sowie ein damit hergestelltes strahlungsempfindliches Aufzeichnungsmaterial, das zur Herstellung von Photoresists und elektronischen Bauteilen geeignet ist.

α-Hydroxymethyl-benzoin-sulfonsäureester, die unter der Einwirkung aktinischer Strahlung Sulfonsäuren bilden, sind in der DE-A 19 19 678 (= US-A 3 732 273) beschrieben. In der EP-A 0 166 682 (= US-A 4 618 564) sind positiv-arbeitende strahlungsempfindliche Gemische offenbart, die neben einem Bindemittel diese Benzoin-sulfonsäureester enthalten. Die Gemisch werden in erster Linie zur Herstellung von Leiterplatten verwendet. Für den Einsatz in der UV-Lithographie sind sie ungeeignet, da sie nur wenig strahlungsempfindlich sind, extrem schlechte Absorptionseigenschaften im UV-Bereich zeigen und nur eine geringe Auflösung zulassen, so daß Strukturen von weniger als 0,5 Mikrometer unter praxisgerechten Bedingungen nicht mehr aufgelöst werden.

Die stetige Verkleinerung der Strukturdimensionen bis in Größenordnungen von weniger als 0,5 Mikrometer, insbesondere bei Halbleiterchips, ist nur möglich durch den Einsatz lithographischer Techniken, bei denen Strahlung einer kurzen Wellenlänge, wie UV-, Röntgen- oder Elektronenstrahlen, verwendet wird. Die Resistgemische, die auf die Halbleitersubstrate während der Herstellung der Chips aufgetragen werden, müssen entsprechend angepaßt sein.

Für solche hochauflösenden Resists sind bereits sogenannte "chemisch verstärkte" strahlungsempfindliche Gemische bekannt, die neben einem Bindemittel und einer säurebildenden Verbindung noch eine Verbindung mit einer säurespaltbaren C-O-C-Bindung enthalten. Ein solches Gemisch ist z.B. in der DE-A 23 06 248 (= US-A 3 779 778) offenbart. Bei Bestrahlung einer Schicht aus einem Gemisch dieser Art wird in den bestrahlten Bereichen von der säurebildenden Verbindung eine starke Säure freigesetzt, die dann die Spaltung von C-O-C- oder C-O-Si-Bindungen in der säurespaltbaren Verbindung bewirkt. Auf diese Weise wird die Löslichkeit der bestrahlten Bereichen in einem wäßrig-alkalischen Entwickler stark erhöht, so daß eine bildmäßige Differenzierung möglich ist.

Als Verbindungen, die bei Bestrahlung eine starke Säure bilden, wurden bisher insbesondere Onium-Salze, wie Diazonium-, Phosphonium-, Sulfonium- und Jodonium-Salze von nicht nucleophilen Säuren, wie HSbF₆, HAsF₆, oder HPF₆ verwendet. Daneben sind Halogenverbindungen, insbesondere Trichlormethyltriazin-Derivate oder Trichlormethyloxadiazol-Derivate, o-Chinondiazidsulfochloride, o-Chinondiazid-4-sulfonsäureester, Organometall-Organohalogen-Kombinationen, Bis(sulfonyl)diazomethane oder Sulfonyl-carbonyl-diazomethane einsetzbar.

Die Verwendung derartiger photolytischer Säurebildner bringt aber Nachteile mit sich, die ihre Einsatzmöglichkeiten drastisch einschränken. So sind z.B. viele der Oniumsalze toxisch, nur in wenigen Lösemitteln löslich und liefern bei der Photolyse stark korrodierend wirkende Brönsted-Säuren. Mit ihnen werden zudem häufig unerwünschte Fremdatome eingeführt, die besonders in der Mikrolithographie zu Prozeßstörungen führen können. Auch die Halogenverbindungen sowie die Chinondiazidsulfonsäurechloride bilden stark korrosiv wirkende Halogenwasserstoffsäuren. Sie besitzen ferner auf bestimmten Substraten nur eine begrenzte Haltbarkeit.

Die α-Sulfonyldiazomethane bilden unter der Einwirkung aktinischer Strahlung ebenfalls wenig bewegliche Sulfonsäuren. Ihre thermische Stabilität ist jedoch ebenso unzureichend. Ein weiterer Nachteil dieser Verbindungen ist ihre unerwünscht hohe Absorption im UV-Bereich. Dies gilt auch für Disulfone der allgemeinen Formel R-SO₂-SO₂-R', die darüber hinaus in vielen der üblicherweise verwendeten Lösemittel nur schlecht löslich sind. Die photochemische Reaktion verläuft zudem mit einer unbefriedigenden Quantenausbeute. Die Resistformulierungen absorbieren Strahlung der Wellenlänge 248 nm in beträchtlichem Maße. Die Empfindlichkeit gegenüber Strahlung dieser Wellenlänge liegt im Bereich von 50 bis 100 mJ/cm². Praxisgerechte Strukturen einer Größenordnung von 0,5 µm und weniger lassen sich mit solchen Resists nicht abbilden.

Aufgabe der Erfindung war es, ein strahlungsempfindliches Gemisch herzustellen, das die aufgeführten Nachteile nicht mehr zeigt. Es wurde herausgefunden, daß man dann ein strahlungsempfindliches Gemisch erhält, mit dem sich ein hochauflösendes, UV-sensitives Aufzeichnungsmaterial herstellen läßt, wenn man zu dem aus der EP-A 0 166 682 bekannten Gemisch eine Verbindung mit säurespaltbaren C-O-C- oder C-O-Si-Bindungen hinzufügt.

Gegenstand der vorliegenden Erfindung ist demgemäß ein positiv-arbeitendes strahlungsempfindliches Gemisch, das
a) einen Sulfonsäureester in einem Anteil von 0,5 bis 5 Gew.-%, bezogen auf das Gesamtgewicht der nichtflüchtigen Bestandteile im Gemisch, der unter der Einwirkung aktinischer Strahlung starke Säure bildet und der allgemeinen Formeln I oder II 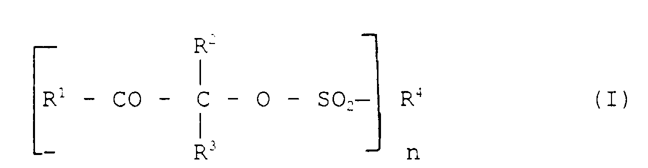 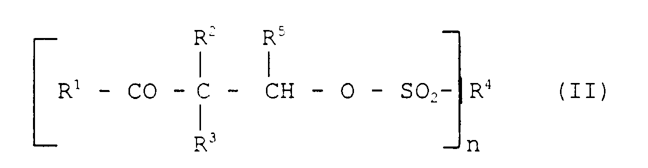 entspricht, worin
   - R¹: ein ein- oder mehrkerniger aromatischer oder nicht-aromatischer isocyclischer Rest mit 6 bis 14 Kohlenstoffatomen oder ein ein- oder mehrkerniger aromatischer heterocyclischer Rest mit 4 bis 11 Kohlenstoffatomen, wobei das Heteroatom ein Sauerstoff-, Schwefel- oder Stickstoffatom ist,
   - R²: ein Wasserstoffatom, eine Hydroxy-, (C₁-C₄)Alkoxy-, Trimethylsilanyloxy-, Acetoxy-, eine unsubstituierte oder substituierte (C₁-C₁₀)Alkyl-, eine unsubstituierte oder substituierte (C₆-C₁₄)Aryl- oder Aroylgruppe, in den Sulfonsäureestern der allgemeinen Formel II auch eine (C₁-C₄)Alkansulfonyloxy- oder Benzolsulfonyloxygruppe,
   - R³: ein Wasserstoffatom oder eine der für R² genannten Gruppen, eine unsubstituierte oder substituierte Phenylgruppe, (C₂-C₁₀)Alkoxycarbonyl-, Cyano-, Carbamoyl-, (C₁-C₆)Alkylcarbamoyl-, Phenylcarbamoylgruppe, oder die Reste R² und R³ zusammen Bestandteil eines 4- bis 6-gliedrigen isocyclischen Ringes sind,
   - R⁴: im Fall n = 1 eine geradkettige oder verzweigte, unsubstituierte oder substituierte (C₁-C₁₅)Alkylgruppe, eine Trifluormethyl-, Trichlormethyl-, (C₄-C₆)Cycloalkyl-, eine unsubstituierte oder substituierte Phenyl-, [1]Naphthyl- oder [2]Naphthylgruppe, Dihydro- oder Tetrahydronaphthylgruppe, eine (C₇-C₁₅)Aralkylgruppe oder eine (C₄-C₁₂)Heteroarylgruppe,
   im Fall n = 2 ein Alkylen-, Arylen- oder Heteroarylenrest und
   - R⁵: ein Wasserstoffatom, eine unsubstituierte oder substituierte (C₁-C₈)Alkylgruppe, eine Trichlormethyl-, (C₂-C₆)Alkenyl, (C₅-C₆)Cycloalkylgruppe, eine unsubstituierte oder substituierte (C₆-C₁₀)-Aryl- oder (C₈-C₁₂)Aralkenylgruppe, eine Furyl- oder Thienylgruppe ist, und
b) ein in Wasser unlösliches, in wäßrig-alkalischen Lösungen dagegen lösliches, zumindest quellbares Bindemittel enthält,
das dadurch gekennzeichnet ist, daß es zusätzlich eine Verbindung mit mindestens einer durch Säure spaltbaren C-O-C- oder C-O-Si-Bindung enthält, ausgewählt aus folgenden Verbindungsklassen
a) Verbindungen mit mindestens einer Orthocarbonsäureester- und bzw. oder Carbonsäureamidacetalgruppe, wobei die Verbindungen auch polymeren Charakter haben und die genannten Gruppen in der Hauptkette oder seitenständig auftreten können,
b) oligomere oder polymere Verbindungen mit wiederkehrenden Acetal- und/oder Ketalgruppen in der Hauptkette,
c) Verbindungen mit mindestens einer Enolether- oder N-Acyliminocarbonatgruppe,
d) cyclische Acetale oder Ketale von β-Ketoestern oder -amiden,
e) Verbindungen mit Silylethergruppen,
f) Verbindungen mit Silylenolethergruppen
g) Monoacetale bzw. Monoketale von Aldehyden bzw. Ketonen, deren Löslichkeit im Entwickler zwischen 0,1 und 100 g/l beträgt,
h) Ether abgeleitet aus tertiären Alkoholen,
i) Carbonsäureester und Carbonate, deren Alkoholkomponente ein Allylalkohol ist, und
j) N,O-Acetale, insbesondere N,O-Polyacetale,
mit Ausnahme von Verbindungen, die sowohl eine Silylethergruppe als auch eine Carbonsäureestergruppe aufweisen.

Diese Verbindungsklassen sind z. B. aus folgenden Dokumenten bekannt: a) aus DE-A 26 10 842 und 29 28 636, b) aus DE-A 23 06 248 und 27 18 254, c)aus EP-A 0 006 626 und 0 006 627, d) aus EP-A 0 202 196, e) aus DE-A 35 44 165 und 36 01 264, f) aus DE-A 37 30 785 und 37 30 783, g) aus DE-A 37 30 787, h) aus US-A 4 603 101, i) aus US-A 4 491 628 sowie aus dem Artikel von J. M. Fréchet et al., J. Imaging Sci. 30, 59-64 (1986)], und j) aus DE-A 41 12 968.

Bevorzugt sind Sulfonsäureester der allgemeinen Formeln I und II mit n = 1.

Der Rest R¹ ist bevorzugt eine Phenyl-, Naphthyl-, Tetrahydronaphthyl-, Anthryl- oder Phenanthrylgruppe. Von den heteroaromatischen Resten R¹ sind solche mit nur einem Heteroatom, wie Furyl-, Thienyl- und Indolylgruppen bevorzugt. Der Rest R¹ kann unabhängig voneinander ein- oder mehrfach substituiert sein, insbesondere mit Fluor-, Chlor- oder Bromatomen, Hydroxy-, Nitro-, Alkanoyloxy-, tert.-Butoxycarbonyloxy-, Tetrahydropyranyloxy-, (C₁-C₁₂)Alkyl-, Phenoxy-, Phenylmercapto-, (C₁-C₈)Alkylmercapto-, 2-Hydroxyethylmercapto-, (C₁-C₄)Alkansulfonyl-, (C₁-C₄)Alkansulfonyloxy-, Benzolsulfonyl-, (C₂-C₆)Alkoxycarbonyl-, (C₁-C₄)Alkylamino-, Di(C₁-C₄)alkylamino-, Benzoylamino-, (C₂-C₅)Alkanoylamino- oder Benzoylgruppen.

R¹ ist bevorzugt eine unsubstituierte oder substituierte Phenylgruppe. Als Substituenten an der Phenylgruppe können unabhängig voneinander insbesondere Halogenatome, Hydroxy-, Methoxy-, oder (C₂-C₆)Alkanoyloxygruppen, säurespaltbare Gruppen, wie tert.-Butoxycarbonyloxy-, und Tetrahydropyranyloxygruppen, aber auch Cyano-, (C₁-C₄)Alkansulfonyl-, (C₁-C₄)Alkansulfonyloxy- oder Benzolsulfonyloxygruppen auftreten.

R² ist bevorzugt ein Wasserstoffatom oder eine (C₁-C₄)-Alkylgruppe, eine unsubstituierte oder substituierte Phenyl- oder Benzoylgruppe, in den Sulfonsäureestern der allgemeinen Formel II daneben auch eine Hydroxy-, Acetoxy, (C₁-C₄)-Alkansulfonyloxy- oder Benzolsulfonyloxygruppe.

R³ ist bevorzugt ein Wasserstoffatom, eine (C₁-C₄)Alkyl- oder Phenylgruppe.

R⁴ ist im Fall n = 1 bevorzugt eine unsubstituierte oder substituierte (C₁-C₈)Alkylgruppe, eine unsubstituierte oder mit Halogenatomen, Nitro-, Cyano-, Trifluormethyl-, (C₁-C₆)-Alkyl- oder Phenoxygruppen substituierte Phenyl-, Naphthyl-, Dihydronaphthyl- oder Tetrahydronaphthylgruppe. Die Phenyl- und Naphthylgruppen können auch mit Diazo- und Oxogruppen substituiert sein. Beispiele hierfür sind Methansulfonylmethyl-, 4-Pentyl-phenyl-, 4-(2-Chlor-6-nitro-phenoxy)-phenyl- und 3,5-Dichlor-4-(2-chlor-4-nitro-phenoxy)-phenylgruppen, daneben auch 1,2-Naphthochinon-2-diazid-4- oder 5-ylgruppen. Bevorzugt von den Heteroarylgruppen sind 4- und 5-Benzolsulfonyl-thiophen-2-yl-, 5-(Pyridin-2-yl)-thiophen-2-yl-, 5-(5-Nitro-pyridin-2-ylsulfonyl)-thiophen-2-yl-, 5-(3-Chlor-5-trifluormethyl-pyridin-2-ylsulfonyl)-thiophen-2-yl-, 5-(1-Methyl-5-trifluormethyl-pyrazol-3-yl)-thiophen-2-yl-, 3-Methyl-benzo[b]thiophen-2-yl-, Benzo[c][1,2,5]oxadiazol-4-yl- und Benzo[c][1,2,5]thiadiazol-4-yl-Gruppen. Im Fall n = 2 ist R⁴ bevorzugt ein Ethan-1,2-diyl-, Propan-1,3-diyl- usw. bis Octan-1,8-diylrest, ein ortho-, meta- oder para-Phenylenrest, eine 4,4'-Oxy-diphenyl-, ein Naphthalin-1,2-, 1,3-, 1,4- oder 1,5-diyl- oder ein 5-Chlor-thiophen-2,4-diyl-Rest.

R⁵ ist bevorzugt ein Wasserstoffatom oder eine unsubstituierte oder durch Halogenatome, (C₁-C₄)Alkoxy- oder Phenylgruppen substituierte Phenylgruppe.

Besonders bevorzugt sind Sulfonsäureester von α-Hydroxymethyl-benzoinen oder deren Derivaten. Die Sulfonsäureester der Derivate entsprechen der oben angegebenen allgemeinen Formel II, worin R⁵ ein Wasserstoffatom ist.

Diese Verbindungen sind deshalb besonders geeignet, weil sie mit einer hohen Quantenausbeute photolytisch Sulfonsäure freisetzen und dennoch eine ausreichende thermische Stabilität besitzen.

Die Herstellung der Sulfonsäureester der allgemeinen Formeln I oder II erfolgt nach Verfahren, die dem Fachmann allgemein bekannt sind. Beschrieben sind solche Verfahren z.B. in der GB-A 2 120 263.

Die Tatsache, daß Sulfonsäureester der allgemeinen Formeln I und II bei Bestrahlung über eine sogenannte α-Spaltung (Norrish-Typ-I-Spaltung) Sulfonsäuren bilden, war bekannt (s. H.J. Hagemann et al., Makromol. Chem. **185** [1984] 1795). Es wurde stets angegeben, daß Sulfonsäuren bei der Bestrahlung nur in einer geringen Quantenausbeute gebildet werden. α-Hydroxymethyl-benzoinsulfonsäureester wurden bisher als Photoinitiatoren für radikalische Vernetzungen verwendet (DE-A 22 21 335 = US-A 4 107 012, DE-A 26 00 318 = US-A 4 141 806, EP-A 0 037 152, EP-A 0 037 604). Ihre Verwendung als säurebildende Komponente in "chemisch verstärkten" strahlungsempfindlichen Gemischen wurde bisher nicht in Erwägung gezogen.

Es war überraschend, daß die in den erfindungsgemäßen Gemischen eingesetzten Verbindungen der allgemeinen Formeln I und II unter der Einwirkung von Strahlung eine genügende Menge an ausreichend starker Säure liefern, so daß die mit den Gemischen hergestellten Resistbilder eine hohe Auflösung und ein klares Profil zeigen. Besonders überraschend war es, daß diese Verbindungen auch unter der Einwirkung von UV-2 Strahlung, insbesondere von Strahlung mit einer Wellenlänge von 248 nm, in ausreichendem Maße Säure liefern, nachdem bekannt war, daß sie in diesem Wellenlängenbereich eine sehr starke Absorption aufweisen und nicht bleichbar sind. Es war daher nicht zu erwarten, daß auch in den Bereichen nahe der Substratoberfläche in ausreichendem Maße Säure gebildet wird. Üblichereise zeigen die Verbindungen der allgemeinen Formeln I und II von allen Resistbestandteilen die höchste molare Absorption.

In dem erfindungsgemäßen Gemisch können auch verschiedene Verbindungen der allgemeinen Formel I und/oder II als Säurebildner enthalten sein. Daneben können auch noch andere Säurebildnern Verwendung finden. Solche zusätzlichen Säurebildner sind z.B. die in der DE-A 41 12 971 beschriebenen mehrfunktionellen Sulfonsäureester von 2,4,6-Tris-(2-hydroxy-ethoxy)-[1,3,5]triazin oder auch die in der Einleitung genannten säurebildenden Verbindungen. Gemische mit solchen zusätzlichen Säurebildnern sind jedoch nicht bevorzugt.

Der Anteil an säurebildenden Verbindungen insgesamt wie auch der an Verbindungen der allgemeinen Formeln I und II im erfindungsgemäßen Gemisch liegt im allgemeinen bei 0,5 bis 25 Gew.-%, bevorzugt bei 1 bis 5 Gew.-%, jeweils bezogen auf das Gesamtgewicht der nichtflüchtigen Bestandteile im Gemisch.

Es können auch Mischungen der vorgenannten säurespaltbaren Verbindungen eingesetzt werden. Von den genannten Verbindungen sind besonders die mit mindestens einer durch Säure spaltbaren C-O-C-Bindung bevorzugt, d. h. die Verbindungen der Klassen (a), (b), (g) und (i) und (j). Unter Typ (b) sind besonders die polymeren Acetale hervorzuheben; von den säurespaltbaren Materialien des Typs (g) insbesondere diejenigen, die sich von Aldehyden bzw. Ketonen mit einem Siedepunkt über 150 °C, vorzugsweise über 200 °C, ableiten. Gemische mit verschiedenen säurespaltbaren Verbindungen sind allgemein nicht bevorzugt.

Der Anteil der säurespaltbaren Verbindung(en) liegt allgemein bei 1 bis 50 Gew.-%, bevorzugt 10 bis 40 Gew.-%, jeweils bezogen auf das Gesamtgewicht der Feststoffe des strahlungsempfindlichen Gemisches.

Das erfindungsgemäße strahlungsempfindliche Gemisch enthält ferner mindestens ein polymeres, in Wasser unlösliches, in wäßrig-alkalischen Lösungen dagegen lösliches, zumindest quellbares Bindemittel. Das Bindemittel zeichnet sich im besonderen dadurch aus, daß es mit den übrigen Bestandteilen des erfindungsgemäßen strahlungsempfindlichen Gemisches gut verträglich ist und insbesondere im Wellenlängenbereich von 190 bis 300 nm eine möglichst geringe Eigenabsorption, d.h. eine hohe Transparenz, aufweist. Bindemittel auf der Basis von Novolak-Kondensationsharzen, die in der Regel in Kombination mit Naphthochinondiaziden als photoaktive Komponenten eingesetzt werden, erfüllen diese Bedingung nicht. Zwar lassen Novolak-Kondensationsharze nach bildmäßiger Belichtung in den nicht belichteten Bereichen eine Erniedrigung der Löslichkeit gegenüber wäßrig-alkalischen Entwicklern erkennen, doch ist ihre Eigenabsorption im Bereich der für die Bestrahlung gewünschten kurzen Wellenlänge unerwünscht hoch.

Novolak-Kondensationsharze können aber in Mischung mit anderen als Bindemittel geeigneten Harzen mit höherer Transparenz eingesetzt werden. Die Mischungsverhältnisse richten sich dabei vorwiegend nach der Art des mit dem Novolakharz zu mischenden Bindemittels. Insbesondere spielen dessen Grad an Eigenabsorption im genannten Wellenlängenbereich, aber auch die Mischbarkeit mit den anderen Bestandteilen des strahlungsempfindlichen Gemisches eine entscheidende Rolle. Im allgemeinen kann aber das Bindemittel des erfindungsgemäßen strahlungsempfindlichen Gemisches bis zu 30 Gew.-%, insbesondere bis zu 20 Gew.-%, eines Novolak-Kondensationsharzes enthalten.

Als Bindemittel geeignet sind Homo- oder Copolymere des 4-Hydroxystyrols sowie seiner Alkylderivate, z.B. des 3-Methyl-4-hydroxystyrols, sowie Homo- oder Copolymere anderer Vinylphenole, z. B. des 3-Hydroxystyrols oder der Ester oder Amide von Acrylsäure mit phenolischen Gruppen aufweisenden Aromaten. Als Comonomere können polymerisierbare Verbindungen wie Styrol, Methyl(meth)acrylat oder ähnliche eingesetzt werden. Gemische mit erhöhter Plasmabeständigkeit werden erhalten, wenn zur Herstellung der Bindemittel Silicium enthaltende Vinylmonomere, z. B. Vinyltrimethylsilan, mitverwendet werden. Die Transparenz dieser Bindemittel ist im Deep-UV-Bereich im allgemeinen höher, so daß eine verbesserte Strukturierung möglich ist. Mit gleichem Erfolg lassen sich auch Homo- oder Copolymere des Maleinimids verwenden. Auch diese Bindemittel zeigen hohe Transparenz im Deep-UV-Bereich. Als Comonomere werden auch hier bevorzugt Styrol, substituierte Styrole, Vinylether, Vinylester, Vinylsilylverbindungen oder (Meth)acrylsäureester eingesetzt. Schließlich sind darüber hinaus auch Copolymere des Styrols mit Comonomeren verwendbar, die in wäßrig alkalischen Lösungen eine Löslichkeitserhöhung bewirken.

Hierzu zählen beispielsweise Maleinsäureanhydrid und Maleinsäurehalbester.

Die genannten Bindemittel können auch untereinander gemischt werden, sofern sich dadurch die optische Qualität des strahlungsempfindlichen Gemisches nicht verschlechtert. Bindemittelgemische sind jedoch nicht bevorzugt.

Die Extinktion des Bindemittels bzw. der Kombination von Bindemitteln für Strahlung der Wellenlänge 248 nm beträgt bevorzugt weniger als 0,35, besonders bevorzugt weniger als 0,25 µm⁻¹.

Die Glasübergangstemperatur des Bindemittels bzw. der Kombination von Bindemitteln liegt vorteilhaft bei mindestens 120 °C.

Der Anteil des Bindemittels beträgt im allgemeinen 1 bis 95 Gew.-%, bevorzugt 5 bis 90 Gew.-%, besonders bevorzugt 55 bis 85 Gew.-%, jeweils bezogen auf das Gesamtgewicht der festen Anteile des strahlungsempfindlichen Gemisches.

Die erfindungsgemäßen Gemische können schließlich noch weitere Komponenten, wie Farbstoffe, Pigmente, Weichmacher, Netzmittel und Verlaufmittel enthalten. Zur Erfüllung spezieller Erfordernisse, wie Flexibilität, Haftung und Glanz, können noch Verbindungen, wie Polyglykol, Celluloseether, z. B. Ethylcellulose, zugesetzt sein.

Soll ein Substrat beschichtet werden, so wird das erfindungsgemäße strahlungsempfindliche Gemisch zweckmäßig in einem Lösemittel oder in einer Kombination von Lösemitteln gelöst. Hierfür besonders geeignet sind Glykole, wie Ethylenglykol und Propylenglykol sowie die davon abgeleiteten Mono- und Dialkylether, besonders die Mono- und Dimethylether sowie die Mono- und Diethylether, Ester abgeleitet aus aliphatischen (C₁-C₆)Carbonsäuren und entweder (C₁-C₈)Alkanolen oder (C₁-C₈)Alkandiolen oder (C₁-C₆)Alkoxy-(C₁-C₈)alkanolen, beispielsweise Ethylacetat, Hydroxyethylacetat, Alkoxyethylacetat, n-Butylacetat, Propylenglykolmonoalkyletheracetat, insbesondere Propylenglykolmethyletheracetat und Amylacetat, Ether, wie Tetrahydrofuran und Dioxan, Ketone, wie Methylethylketon, Methylisobutylketon, Cyclopentanon und Cyclohexanon, N,N-Dialkyl-carbonsäureamide, wie N,N-Dimethylformamid und N,N-Dimethylacetamid, aber auch Hexamethylphosphorsäuretriamid, N-Methyl-pyrrolidin-2-on und Butyrolacton, sowie beliebige Mischungen davon. Besonders bevorzugt von diesen sind die Glykolether, aliphatischen Ester und Ketone.

Letztendlich hängt die Wahl des Lösemittels bzw. Lösemittelgemisches ab von dem angewendeten Beschichtungsverfahren, der gewünschten Schichtstärke und den Trocknungsbedingungen. Ebenso müssen die Lösemittel unter den angewendeten Bedingungen gegenüber den übrigen Schichtbestandteilen chemisch inert sein.

Die mit den genannten Lösemitteln hergestellte Lösung hat in der Regel einen Feststoffgehalt von 5 bis 60 Gew.-%, vorzugsweise 10 bis 40 Gew.-%.

Gegenstand der Erfindung ist schließlich auch ein strahlungsempfindliches Aufzeichnungsmaterial, das im wesentlichen aus einem Substrat und einer darauf befindlichen strahlungsempfindlichen Schicht aus dem erfindungsgemäßen Gemisch besteht.

Als Substrate kommen alle Materialien in Frage, aus denen Kondensatoren, Halbleiter, mehrlagige gedruckte Schaltungen oder integrierte Schaltkreise bestehen bzw. hergestellt werden können. Speziell sind Siliciumsubstrate zu nennen, die auch thermisch oxidiert und/oder mit Aluminium beschichtet, aber auch dotiert sein können. Daneben sind alle anderen in der Halbleitertechnologie üblichen Substrate möglich, wie Siliciumnitrid, Galliumarsenid und Indiumphosphid. Weiterhin kommen die aus der Flüssigkristalldisplay-Herstellung bekannten Substrate in Frage, wie z. B. Glas und Indium-Zinnoxid, ferner Metallplatten und -folien, beispielsweise aus Aluminium, Kupfer, Zink, Bimetall und Trimetall. Verwendbar sind auch elektrisch nichtleitende Folien, die mit Metallen bedampft sind, und Papier. Diese Substrate können thermisch vorbehandelt, oberflächlich aufgerauht, angeätzt oder, zur Verbesserung erwünschter Eigenschaften, z. B. zur Erhöhung der Hydrophilie, mit Chemikalien vorbehandelt sein.

Um der strahlungsempfindlichen Schicht einen besseren Zusammenhalt und/oder eine bessere Haftung auf der Substratoberfläche zu verleihen, kann in ihr ein Haftvermittler enthalten sein. Bei Silicium- bzw. Siliciumdioxid-Substraten kommen hierfür Haftvermittler vom Aminosilan-Typ, wie z. B. 3-Aminopropyl-triethoxy-silan oder Hexamethyl-disilazan, in Frage.

Geeignete Träger für die Herstellung von photomechanischen Aufzeichnungsschichten, wie Druckformen für den Hochdruck, Flachdruck, Siebdruck und Flexodruck sind besonders Aluminiumplatten, die gegebenenfalls vorher anodisch oxidiert, gekörnt und/oder silikatisiert werden, daneben Zink- und Stahlplatten, die gegebenenfalls verchromt werden, sowie Kunststoffolien und Papier.

Als Strahlungsquellen für die bildmäßige Bestrahlung eignen sich besonders Metallhalogenidlampen, Kohlebogenlampen, Xenonlampen und Quecksilberdampflampen. Ebenso kann eine Belichtung mit energiereicher Strahlung wie Laser-, Elektronen- oder Röntgenstrahlung erfolgen. Besonders bevorzugt sind jedoch Lampen, die Licht einer Wellenlänge von 190 bis 260 nm ausstrahlen können, d.h. insbesondere Xenon- und Quecksilberdampflampen. Darüber hinaus lassen sich auch Laserlichtquellen verwenden, z. B. Excimerlaser, insbesondere KrF- oder ArF-Laser, die bei 248 bzw. 193 nm emittieren. Die Strahlungsquellen müssen in den genannten Wellenlängenbereichen eine ausreichende Emission aufweisen.

Die Stärke der lichtempfindlichen Schicht hängt vom Verwendungszweck ab. Sie beträgt im allgemeinen zwischen 0,1 und 100 µm, bevorzugt zwischen 0,5 und 10 µm, besonders bevorzugt um 1,0 µm.

Das strahlungsempfindliche Aufzeichnungsmaterial wird zweckmäßig durch Auftragen des strahlungsempfindlichen Gemisches auf das Substrat, z.B. durch Aufsprühen, Fließbeschichten, Walzen, Schleuder- und Tauchbeschichten hergestellt. Danach wird das Lösemittel durch Verdampfen entfernt, so daß auf der Oberfläche des Substrats die strahlungsempfindliche Schicht zurückbleibt. Die Entfernung des Lösemittels kann durch Erhitzen der Schicht auf Temperaturen bis zu 150 °C gefördert werden. Das Gemisch kann aber auch zunächst auf obengenannte Weise auf einen Zwischenträger aufgetragen werden, von dem aus es unter Druck und erhöhter Temperatur auf das endgültige Trägermaterial übertragen wird. Als Zwischenträger können grundsätzlich alle auch als Trägermaterialien geeigneten Materialien Anwendung finden. Anschließend wird die Schicht bildmäßig bestrahlt. Danach behandelt man die Schicht mit einer Entwicklerlösung, die die bestrahlten Bereiche der Schicht löst und entfernt, so daß ein Abbild der bei der bildmäßigen Bestrahlung verwendeten Vorlage auf der Substratoberfläche verbleibt.

Als Entwickler eignen sich besonders wäßrige Lösungen, die Silikate, Metasilikate, Hydroxide, Hydrogen- und Dihydrogenphosphate, Carbonate oder Hydrogencarbonate von Alkalimetall-, Erdalkalimetall- und/oder Ammoniumionen enthalten, aber auch Ammoniak und dergleichen. Metallionenfreie Entwickler sind bevorzugt. Der Gehalt dieser Substanzen in der Entwicklerlösung beträgt im allgemeinen 0,1 bis 15 Gew.-%, vorzugweise 0,5 bis 5 Gew.-%, bezogen auf das Gewicht der Entwicklerlösung. Den Entwicklern können gegebenenfalls geringe Mengen eines Netzmittels zugesetzt sein, die die Ablösung der löslichen Bereiche der Schicht fördern.

Die entwickelten Schichtstrukturen können nachgehärtet werden. Dies geschieht im allgemeinen durch Erhitzen auf einer hot plate bis zu einer Temperatur unterhalb der Fließtemperatur und anschließendes ganzflächiges Belichten mit dem UV-Licht einer Xenon-Quecksilber-Dampflampe (Bereich von 200 bis 250 nm). Durch die Nachhärtung werden die Bildstrukturen vernetzt, so daß sie im allgemeinen eine Fließbeständigkeit bis zu Temperaturen von über 200 °C aufweisen. Die Nachhärtung kann auch ohne Temperaturerhöhung allein durch Bestrahlen mit energiereichem UV-Licht erfolgen.

Verwendung findet das erfindungsgemäße strahlungsempfindliche Gemisch bei der Herstellung von integrierten Schaltungen oder von diskreten elektrischen Bausteinen mit lithographischen Prozessen, da es eine hohe Lichtempfindlichkeit aufweist, besonders bei Bestrahlung mit Licht einer Wellenlänge zwischen 190 und 300 nm. Die entwickelte Resistschicht dient dabei als Maske für die folgenden Prozeßschritte. Solche Schritte sind z. B. das Ätzen des Schichtträgers, das Implantieren von Ionen in den Schichtträger oder das Abscheiden von Metallen oder anderen Materialien auf dem Schichtträger.

Die nachstehend beschriebenen Beispiele illustrieren die Erfindung, sollen aber nicht beschränkend wirken. Gt steht dabei für Gewichtsteile, Vt für Volumenteile. Gewichtsteile verhalten sich zu Volumenteilen wie Gramm zu Kubikzentimeter.

### Beispiel 1:

Es wurde eine Beschichtungslösung hergestellt aus

| | |
|---|---|
| 65 Gt | eines Poly(4-hydroxy-styrols) mit einem mittleren Molekulargewicht (MW) von 18.800 g/mol, |
| 33,8 Gt | eines N,O-Polyacetals, hergestellt aus 4-Chlor-benzaldehyd und Isobutylcarbamidsäure-(2-hydroxy-ethylester) (MW: 8.300 g/mol), |
| 1,2 Gt | 1-(4-Brom-phenyl)-3-(naphthalin-2-ylsulfonyloxy)-2-methansulfonyloxy-2-phenyl-butan-1-on (Formel II, R¹ = 4-Brom-phenyl, R² = O-SO₂-CH₃, R³ = C₆H₅, R⁴ = [2]Naphthyl, R⁵ = Methyl, n = 1) und |
| 400 Gt | Propylenglykol-monomethylether-acetat. |

Die Beschichtungslösung wurde durch einen Filter mit einem Porendurchmesser von 0,2 µm filtriert und auf einen mit einem Haftvermittler (Hexamethyldisilazan) vorbehandelten Wafer so aufgeschleudert, daß nach der Trocknung bei 120 °C für 1 min auf der hot plate eine Schichtdicke von 1,0 µm erhalten wurde.

Das Aufzeichnungsmaterial wurde bildmäßig unter einer Vorlage mit der UV-Strahlung einer Xenon-Quecksilber-dampflampe (248 nm) mit einer Energie von 32 mJ/cm² bestrahlt und anschließend bei 50 °C für 1 min einem post exposure bake auf einer hot plate unterzogen.

Entwickelt wurde das Aufzeichnungsmaterial mit einer 0,21 n wäßrigen Tetramethylammoniumhydroxid-Lösung (TMAH). Nach einer Entwicklungsdauer von 60 s bei 21 °C waren die bestrahlten Bereiche der Schicht restlos abgelöst. Man erhielt ein fehlerfreies Abbild der Maske mit steilen Resistflanken, wobei auch Strukturen von 0,35 µm und weniger noch detailgetreu aufgelöst waren. Eine Untersuchung der Flanken der Resistprofile mittels Rasterelektronenmikroskopie belegte, daß diese praktisch senkrecht zur Substratoberfläche ausgerichtet waren.

In den folgenden Beispielen wurde analog vorgegangen. Abweichende Parameter sind einzeln angegeben.

### Beispiel 2:

Es wurde eine Beschichtungslösung hergestellt aus

| | |
|---|---|
| 25 Gt | eines Copolymers aus Styrol und 4-Hydroxystyrol (20/80) (MW: 28.000 g/mol), |
| 10,7 Gt | 3,4-Dimethoxy-benzaldehyd-bis (phenoxyethyl)-acetal, hergestellt analog Herstellungsbeispiel 1 der DE-A 37 30 787, |
| 0,71 Gt | 2-(4-Brom-benzolsulfonyloxy)-2-methyl-1-phenyl-propan-1-on (Formel I, R1 = C₆H₅, R² = R³ = CH₃, R4 = 4-Brom-phenyl, n = 1) und |
| 100 Gt | Propylenglykol-monomethylether-acetat. |

Bestrahlungsenergie: 26 mJ/cm²
post-exposure-bake: 80 °C
Entwickler: 0,18 n wäßrige TMAH-Lösung

Es wurde ein detailgetreues Abbild der Vorlage mit steilen Resistflanken erhalten. Die Auflösung der Linien und Gräben betrug 0,7 µm und weniger.

### Beispiel 3:

Ein wie im Beispiel 1 beschichteter Wafer wurde unter einer Vorlage mit der UV-Strahlung eines KrF-Excimer-Lasers (248 nm) mit einer Energie von 25 mJ/cm² bestrahlt. Wie im vorangehenden Beispiel wurde ein originalgetreues Abbild der Vorlage erhalten, in dem auch Strukturen von weniger als 1 µm aufgelöst waren.

### Beispiel 4:

Es wurde eine Beschichtungslösung hergestellt aus

| | |
|---|---|
| 25 Gt | eines Copolymers aus 3-Methyl-4-hydroxy-styrol und 4-Hydroxystyrol (2:1) mit einem mittleren Molekulargewicht von 16.500 g/mol, |
| 10,7 Gt | eines N,O-Polyacetals, hergestellt aus Benzaldehyd und Propylcarbamidsäure-(2-hydroxyethyl-ester) mit einem mittleren Molekulargewicht von 5.000 g/mol, |
| 0,66 Gt | 3-(4-Chlor-benzolsulfonyloxy)-2-hydroxy-1,2-diphenyl-propan-1-on (Formel II, R¹ = R³ = C₆H₅, R² = OH, R⁴ = 4-Chlor-phenyl, R⁵ = H, n = 1) und |
| 100 Gt | Propylenglykol-monoethylether-acetat. |

Bestrahlung mit: KrF-Excimerlaser (248 nm)
Bestrahlungsenergie: 23 mJ/cm²
post-exposure-bake: 60 °C
Entwickler: 0,27 n wäßrige TMAH-Lösung

Es wurde ein detailgetreues Abbild der Vorlage mit steilen Resistflanken erhalten. Die Auflösung der Linien und Gräben betrug bis zu 0,35 µm.

### Beispiel 5:

Es wurde eine Beschichtungslösung hergestellt aus

| | |
|---|---|
| 25 Gt | eines Copolymers aus 3-Methyl-4-hydroxy-styrol und 4-Hydroxystyrol (2:1) mit einem mittleren Molekulargewicht von 16.500 g/mol, |
| 10,7 Gt | eines N,O-Polyacetals, hergestellt aus Benzaldehyd und Propylcarbamidsäure-(2-hydroxyethyl-ester) mit einem mittleren Molekulargewicht von 5.000 g/mol, |
| 0,54 Gt | 1-(4-Chlor-phenyl)-2,3-diphenyl-3-(2,2,2-trifluor-ethansulfonyloxy)-propan-1-on (Formel II, R¹ = 4-Chlor-phenyl, R² = H, R³ = R⁵ = C₆H₅, R⁴ = 2,2,2-Trifluor-ethyl, n = 1) und |
| 100 Gt | Propylenglykol-monoethylether-acetat. |

Bestrahlung mit: KrF-Excimerlaser (248 nm)
Bestrahlungsenergie: 29 mJ/cm²
post-exposure-bake: 60 °C
Entwickler: 0,27 n wäßrige TMAH-Lösung

Es wurde ein detailgetreues Abbild der Vorlage mit steilen Resistflanken erhalten. Die Auflösung der Linien und Gräben betrug bis zu 0,35 µm.

### Beispiel 6:

Es wurde eine Beschichtungslösung hergestellt aus

| | |
|---|---|
| 25 Gt | Poly(3-methyl-4-hydroxystyrol) mit einem mittleren Molekulargewicht von 27.000 g/mol (GPC), |
| 10,7 Gt | eines Polyacetals hergestellt aus Benzaldehyd und N-Butyl-4-hydroxy-butyramid, mit einem mittleren Molekulargewicht von 6.000 g/mol, |
| 0,99 Gt | 1,3-Bis-[2-hydroxy-2-(4-methoxy-phenyl)-3-oxo-3-phenyl-propoxysulfonyl]-benzol (Formel II, R¹ = C₆H₅, R² = OH, R³ = 4-Methoxy-phenyl, R⁴ = m-Phenylen, R⁵ = H, n = 2) und |
| 100 Gt | Propylenglykol-monomethylether-acetat. |

Schleuderdrehzahl: 3.000 U/min
Schichtdicke: 1,07 µm
Bestrahlungsenergie: 27 mJ/cm²
post-exposure-bake: 60 °C
Entwickler: 0,33 n wäßrige TMAH-Lösung

Es wurde ein detailgetreues Abbild der Vorlage erhalten. Linien und Gräben waren bis in eine Größenordnung von 0,4 µm und weniger exakt wiedergegeben. Der Abtrag in den nichtbestrahlten Bereichen ("Dunkelabtrag") betrug weniger als 20 nm.

### Beispiel 7:

Es wurde eine Beschichtungslösung hergestellt aus

| | |
|---|---|
| 50 Gt | eines Copolymers aus 3-Methyl-4-hydroxystyrol und 4-Hydroxystyrol (Molverhältnis 1:1) mit einem mittleren Molekulargewicht von 17.500 g/mol (GPC), |
| 23,2 Gt | eines Poly-orthoesters, hergestellt durch Kondensation von 1 mol Orthoameisensäure-trimethylester und 1 mol 7,7-Bis-hydroxymethylnonan-1-ol, |
| 1,8 Gt | 3-(4-Cyano-benzolsulfonyloxy)-2-hydroxy-1,2-diphenyl-propan-1-on und |
| 300 Gt | Propylenglykol-monomethylether-acetat. |

Schleuderdrehzahl: 3.500 U/min
Trocknung: 110 °C
Bestrahlungsenergie: 17 mJ/cm²
post-exposure-bake: 65 °C
Entwickler: 0,24 n wäßrige TMAH-Lösung

Es wurde ein detailgetreues Abbild der Vorlage mit steilen Resistflanken erhalten. Linien und Gräben waren bis in eine Größenordnung von weniger als 1 µm exakt wiedergegeben.

### Beispiel 8:

Es wurde eine Beschichtungslösung hergestellt aus

| | |
|---|---|
| 6,0 Gt | eines Polymerblends aus Poly(3-methyl-4-hydroxy-styrol) und Poly(4-hydroxystyrol) (2:1) mit einem mittleren Molekulargewicht von 16.000 g/mol bzw. 16.800 g/mol, |
| 3,85 Gt | eines N,O-Polyacetals, hergestellt aus Benzaldehyd und Propylcarbamidsäure-(2-hydroxyethyl-ester) mit einem mittleren Molekulargewicht von 3.500 g/mol, |
| 0,15 Gt | 2-(4-Chlor-phenyl)-2-hydroxy-1-phenyl-3-(1,2,3,4-tetrahydro-naphthalin-5-ylsulfonyloxy)-propan-1-on (Formel II, R¹ = C₆H₅, R² = 4-chlor-phenyl, R³ = OH, R⁴ = 1,2,3,4-Tetrahydro-naphthalin-5-yl, R⁵ = H, n = 1) und |
| 40 Gt | Propylenglykol-monoethylether-acetat. |

Trocknung: 115 °C
Schichtdicke: 0,97 µm
Bestrahlung mit: KrF-Excimerlaser (248 nm)
Bestrahlungsenergie: 27 mJ/cm²
post-exposure-bake: 60 °C
Entwickler: 0,24 n wäßrige TMAH-Lösung

Es wurde ein detailgetreues Abbild der Vorlage mit steilen Resistflanken erhalten. Die Auflösung der Linien und Gräben betrug bis zu 0,40 µm.

### Beispiel 9 (Vergleichsbeispiel):

Es wurde eine Resistformulierung eingesetzt, die dem Beispiel 3 der EP-A 0 166 682 entspricht.
Bestrahlungsenergie: 128 mJ/cm²
Entwickler: 0,27 n wäßrige TMAH-Lösung

Die auf diese Weise erhaltenen Resiststrukturen zeigten ein dreieckiges Profil. Details mit einer Größe von weniger als 1,2 µm waren nicht mehr aufgelöst.

### Beispiel 10 (Vergleichsbeispiel):

Die Resistformulierung des Beispiels 7 wurde derart verändert, daß die dort verwendeten säurebildenden Verbindung (3-(4-Cyano-benzolsulfonyloxy)-2-hydroxy-1,2-diphenyl-propan-1-on) durch die gleiche Menge an 2,6-Dinitrobenzyltosylat ersetzt wurde.
Bestrahlungsenergie: 58 mJ/cm²
Entwickler: 0,27 n wäßrige TMAH-Lösung

Es wurden Strukturen erhalten, die keine praxisgerechte Bilddifferenzierung zeigten. Zudem waren die Oberflächen der Strukturen partiell überbrückt (T-topping) und somit nicht akzeptabel.

## Patentansprüche

1. Positiv arbeitendes strahlungsempfindliches Gemisch, das
a) einen Sulfonsäureester in einem Anteil von 0,5 bis 5 Gew.-%, bezogen auf das Gesamtgewicht der nichtflüchtigen Bestandteile im Gemisch, der unter der Einwirkung aktinischer Strahlung starke Säure bildet und der allgemeinen Formeln I oder II 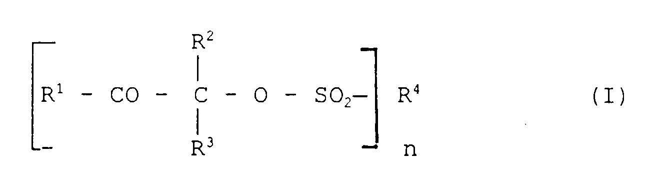 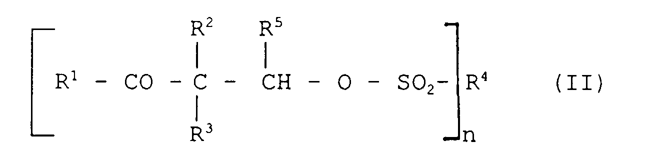 entspricht, worin
R¹ ein ein- oder mehrkerniger aromatischer oder nicht-aromatischer isocyclischer Rest mit 6 bis 14 Kohlenstoffatomen oder ein ein- oder mehrkerniger aromatischer heterocyclischer Rest mit 4 bis 11 Kohlenstoffatomen, wobei das Heteroatom ein Sauerstoff-, Schwefel- oder Stickstoffatom ist,
R² ein Wasserstoffatom, eine Hydroxy-, (C₁-C₄)Alkoxy-, Trimethylsilanyloxy-, Acetoxy-, eine unsubstituierte oder substituierte (C₁-C₁₀)Alkyl-, eine unsubstituierte oder substituierte (C₆-C₁₄)-Aryl- oder Aroylgruppe, in den Sulfonsäureestern der allgemeinen Formel II auch eine (C₁-C₄)Alkansulfonyloxy- oder Benzolsulfonyloxygruppe,
R³ ein Wasserstoffatom oder eine der für R² genannten Gruppen, eine unsubstituierte oder substituierte Phenylgruppe, (C₂-C₁₀)Alkoxycarbonyl-, Cyano-, Carbamoyl-, (C₁-C₆)Alkylcarbamoyl-, Phenylcarbamoylgruppe, oder die Reste R² und R³ zusammen Bestandteil eines 4- bis 6-gliedrigen isocyclischen Ringes sind,
R⁴ im Fall n = 1 eine geradkettige oder verzweigte, unsubstituierte oder substituierte (C₁-C₁₅)Alkylgruppe, eine Trifluormethyl-, Trichlormethyl-, (C₄-C₆)Cycloalkyl-, eine unsubstituierte oder substituierte Phenyl-, [1]Naphthyl- oder [2]Naphthylgruppe, Dihydro- oder Tetrahydronaphthylgruppe, eine (C₇-C₁₅)Aralkylgruppe oder eine (C₄-C₁₂)Heteroarylgruppe,
im Fall n = 2 ein Alkylen-, Arylen- oder Heteroarylenrest und
R⁵ ein Wasserstoffatom, eine unsubstituierte oder substituierte (C₁-C₈)Alkylgruppe, eine Trichlormethyl-, (C₂-C₆)Alkenyl, (C₅-C₆)Cycloalkylgruppe, eine unsubstituierte oder substituierte (C₆-C₁₀)-Aryl- oder (C₈-C₁₂)Aralkenylgruppe, eine Furyl-oder Thienylgruppe ist, und
b) ein in Wasser unlösliches, in wäßrig-alkalischen Lösungen dagegen lösliches, zumindest quellbares Bindemittel enthält,
das dadurch gekennzeichnet ist, daß es zusätzlich eine Verbindung mit mindestens einer durch Säure spaltbaren C-O-C- oder C-O-Si-Bindung enthält, aus gewählt aus den Gruppen
a) Verbindungen mit mindestens einer Orthocarbonsäureester- und bzw. oder Carbonsäureamidacetalgruppe, wobei die Verbindungen auch polymeren Charakter haben und die genannten Gruppen in der Hauptkette oder seitenständig auftreten können,
b) oligomere oder polymere Verbindungen mit wiederkehrenden Acetal- und/oder Ketalgruppen in der Hauptkette,
c) Verbindungen mit mindestens einer Enolether- oder N-Acyliminocarbonatgruppe,
d) cyclische Acetale oder Ketale von β-Ketoestern oder -amiden,
e) Verbindungen mit Silylethergruppen,
f) Verbindungen mit Silylenolethergruppen
g) Monoacetale bzw. Monoketale von Aldehyden bzw. Ketonen, deren Löslichkeit im Entwickler zwischen 0,1 und 100 g/l beträgt,
h) Ether abgeleitet aus tertiären Alkoholen,
i) Carbonsäureester und Carbonate, deren Alkoholkomponente ein Allylalkohol ist, und
j) N,O-Acetale, insbesondere N,O-Polyacetale,
mit Ausnahme von Verbindungen, die sowohl eine Silylethergruppe als auch eine Carbonsäureestergruppe aufweisen.

2. Strahlungsempfindliches Gemisch gemäß Anspruch 1, dadurch gekennzeichnet, daß der Rest R¹ eine Phenyl-, Naphthyl-, Tetrahydronaphthyl-, Anthryl-, Phenanthryl-, Furyl-, Thienyl- oder Indolylgruppe ist.

3. Strahlungsempfindliches Gemisch gemäß Anspruch 1, dadurch gekennzeichnet, daß der Rest R⁵ ein Wasserstoffatom ist.

4. Strahlungsempfindliches Gemisch gemäß einem oder mehreren der Ansprüche 1 bis 3, dadurch gekennzeichnet, daß der Anteil des Bindemittels 1 bis 95 Gew.-%, bevorzugt 5 bis 90 Gew.-%, besonders bevorzugt 55 bis 85 Gew.-%, jeweils bezogen auf das Gesamtgewicht der festen Anteile des strahlungsempfindlichen Gemisches, beträgt.

5. Strahlungsempfindliches Gemisch gemäß einem oder mehreren der Ansprüche 1 bis 4, dadurch gekennzeichnet, daß der Anteil der säurespaltbaren Verbindung(en) 1 bis 50 Gew.-%, bevorzugt 10 bis 40 Gew.-%, jeweils bezogen auf das Gesamtgewicht der Feststoffe des strahlungsempfindlichen Gemisches, beträgt.

6. Positiv arbeitendes strahlungsempfindliches Aufzeichungsmaterial, bestehend aus einem Träger mit einer strahlungsempfindlichen Schicht, dadurch gekennzeichnet, daß die Schicht aus einem Gemisch gemäß einem oder mehreren der Ansprüche 1 bis 5 besteht.

## Claims

1. A positive radiation-sensitive mixture containing
a) a sulfonic acid ester in a proportion of from 0.5 to 5% by weight, based on the total weight of the nonvolatile components in the mixture, which, under the influence of actinic radiation, forms a strong acid and which corresponds to the formula I or II 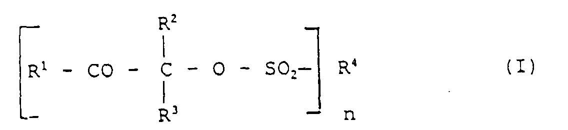 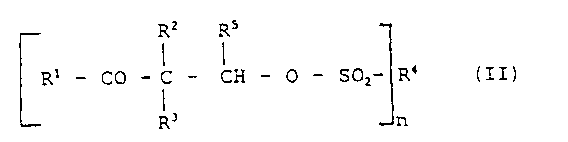 in which
R¹ is a mono- or polynuclear aromatic or nonaromatic isocyclic radical having from 6 to 14 carbon atoms or a mono- or polynuclear aromatic heterocyclic radical having from 4 to 11 carbon atoms, the hetero atom being an oxygen, sulfur or nitrogen atom,
R² is a hydrogen atom, a hydroxyl, (C₁-C₄)alkoxy, trimethylsilanyloxy, acetoxy, an unsubstituted or substituted (C₁-C₁₀)alkyl, an unsubstituted or substituted (C₆-C₁₄)aryl or aroyl group, including, in the case of the sulfonic acid esters of the formula II, a (C₁-C₄)alkanesulfonyloxy or benzenesulfonyloxy group,
R³ is a hydrogen atom or one of the groups mentioned for R², an unsubstituted or substituted phenyl group, (C₂-C₁₀)alkoxycarbonyl, cyano, carbamoyl, (C₁-C₆)alkylcarbamoyl, phenylcarbamoyl group, or the radicals R² and R³ together are a constituent of a 4- to 6-membered isocyclic ring,
R⁴ in the case n = 1 is a straight-chain or branched unsubstituted or substituted (C₁-C₁₅)alkyl group, a trifluoromethyl, trichloromethyl, (C₄-C₆)cycloalkyl, an unsubstituted or substituted phenyl, [1]-naphthyl or [2]naphthyl group, dihydro- or tetrahydronaphthyl group, a (C₇-C₁₅)aralkyl group or a (C₄-C₁₂)heteroaryl group,
in the case n = 2 is an alkylene, arylene or heteroarylene radical and
R⁵ is a hydrogen atom, an unsubstituted or substituted (C₁-C₈)alkyl group, a trichloromethyl, (C₂-C₆) alkenyl, (C₅-C₆) cycloalkyl group, an unsubstituted or substituted (C₆-C₁₀)aryl or (C₈-C₁₂)aralkenyl group, a furyl or thienyl group, and
b) a water-insoluble binder which, however, is soluble or at least swellable in aqueous alkaline solutions,
which comprises in addition a compound having at least one acid-cleavable C-O-C- or C-O-Si- bond, selected from the groups
a) compounds having at least one orthocarboxylic acid ester group and/or carboxamide acetal group, it being possible for the compounds also to be polymeric and for said groups to be present in the main chain or in side chains,
b) oligomeric or polymeric compounds having recurring acetal and/or ketal groups in the main chain,
c) compounds having at least one enol ether or N-acyliminocarbonate group,
d) cyclic acetals or ketals of β-ketoesters or amides,
e) compounds having silyl ether groups,
f) compounds having silylenol ether groups,
g) monoacetals or monoketals of aldehydes or ketones, respectively, whose solubility in the developer is from 0.1 to 100 g/l,
h) ethers derived from tertiary alcohols,
i) carboxylic acid esters and carbonates whose alcohol component is an allyl alcohol, and
j) N,O-acetals, especially N,O-polyacetals,
with the exception of compounds which have both a silyl ether group and a carboxylic acid ester group.

2. The radiation-sensitive mixture as claimed in claim 1, wherein the radical R¹ is a phenyl, naphthyl, tetrahydronaphthyl, anthryl, phenanthryl, furyl, thienyl or indolyl group.

3. The radiation-sensitive mixture as claimed in claim 1, wherein the radical R⁵ is a hydrogen atom.

4. The radiation-sensitive mixture as claimed in one or more of claims 1 to 3, wherein the proportion of the binder is from 1 to 95% by weight, preferably from 5 to 90% by weight, especially preferably from 55 to 85% by weight, in each case based on the total weight of the solid fractions of the radiation-sensitive mixture.

5. The radiation-sensitive mixture as claimed in one or more of claims 1 to 4, wherein the proportion of the acid-cleavable compound(s) is from 1 to 50% by weight, preferably from 10 to 40% by weight, in each case based on the total weight of the solids of the radiation-sensitive mixture.

6. A positive radiation-sensitive recording material, composed of a carrier with a radiation-sensitive layer, wherein the layer comprises a mixture as claimed in one or more of claims 1 to 5.

## Revendications

1. Composition sensible au rayonnement travaillant en positif, qui contient
a) un ester d'acide sulfonique en une concentration de 0,5 à 5% en poids, par rapport au poids total des composants non volatils du mélange, qui forme un acide fort sous l'action de rayonnement actinique et correspond à la formule générale I ou II 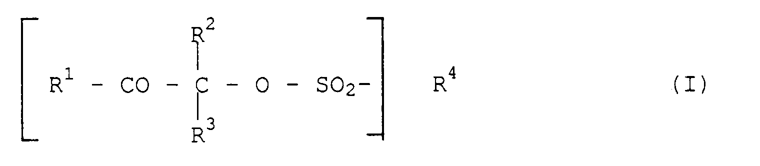 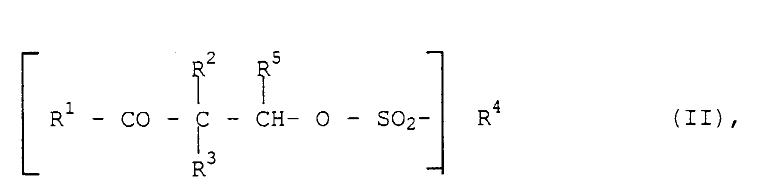 dans laquelle
R¹ représente un groupe isocyclique aromatique ou non aromatique mono ou plurinucléaire avec 6 à 14 atomes de carbone ou un groupe hétérocyclique aromatique mono ou plurinucléaire avec 4 à 11 atomes de carbone, l'hétéroatome étant un atome d'oxygène, de soufre ou d'azote,
R² représente un atome d'hydrogène, un groupe hydroxy, alcoxy en C₁-C₄, triméthylsilanyloxy, acétoxy, un groupe alkyle en C₁-C₁₀ non substitué ou substitué, un groupe aryle en C₆-C₁₄ ou aroyle non substitué ou substitué, parmi les esters d'acide sulfonique de formule générale II aussi un groupe alcanesulfonyloxy en C₁-C₄ ou benzène-sulfonyloxy,
R³ représente un atome d'hydrogène ou un des groupes cités pour R², un groupe phényle non substitué ou substitué, un groupe alcoxycarbonyle en C₂-C₁₀, cyano, carbamoyle, alkylcarbamoyle en C₁-C₆, phénylcarbamoyle, ou les groupes R² et R³ constituent ensemble un noyau isocyclique à 4 à 6 chaînons.
R⁴ dans le cas où n = 1 représente un groupe alkyle en C₁-C₁₅ non substitué ou substitué, à chaîne linéaire ou ramifiée, un groupe trifluorométhyle, trichlorométhyle, cycloalkyle en C₄-C₆, un groupe phényle non substitué ou substitué, [1]naphtyle ou [2]naphtyle, dihydro- ou tétrahydronaphtyle, un groupe aralkyle en C₇-C₁₅ ou un groupe hétéroaryle en C₄-C₁₂,
dans le cas où n = 2 représente un groupe alkylène, arylène ou hétéroarylène et
R⁵ représente un atome d'hydrogène, un groupe alkyle en C₁-C₈ non substitué ou substitué, un groupe trichlorométhyle, alcényle en C₂-C₆, cycloalkyle en C₅-C₆, un groupe aryle en C₆-C₁₀ ou aralcényle en C₈-C₁₂ non substitué ou substitué, un groupe furyle ou thiényle, et
b) un liant insoluble dans l'eau, par contre soluble, ou au moins capable de gonfler dans des solutions aqueuses alcalines,
qui est caractérisé en ce qu'il contient en plus un composé avec au moins une liaison C-O-C ou C-O-Si clivable par un acide, choisie parmi les groupes
a) composés avec au moins un groupe ester d'acide orthocarboxylique et/ou carboxamideacétal, les composés ayant aussi un caractère polymère et les groupes cités pouvant se trouver dans la chaîne principale ou en position ramifiée,
b) composés oligomères ou polymères avec des groupes récurrents acétal et/ou cétal dans la chaîne principale,
c) composés avec au moins un groupe éther énolique ou N-acyliminocarbonate,
d) acétals ou cétals cycliques de β-cétoesters ou -amides,
e) composés avec des groupes silyléther,
f) composés avec des groupes silylénoléther
g) monoacétals ou monocétals d'aldéhydes ou de cétones, dont la solubilité dans le révélateur est située entre 0,1 et 100 g/l,
h) éthers dérivés d'alcools tertiaires,
i) esters d'acides carboxyliques et carbonates, dont le composant alcool est un alcool allylique, et
j) N,O-acétals, en particulier N,O-polyacétals;
à l'exclusion des composés qui présentent à la fois un groupe silyléther et un groupe ester d'acide carboxylique.

2. Composition sensible au rayonnement selon la revendication 1, caractérisée en ce que le groupe R¹ est un groupe phényle, napthyle, tétrahydronaphtyle, anthryle, phénanthryle, furyle, thiényle ou indolyle.

3. Composition sensible au rayonnement selon la revendication 1, caractérisée en ce que le groupe R⁵ est un atome d'hydrogène.

4. Composition sensible au rayonnement selon une ou plusieurs des revendications 1 à 3, caractérisée en ce que le titre du liant s'élève à 1 à 95% en poids, de préférence à 5 à 90% en poids, de manière particulièrement préférée de 55 à 85% en poids, par rapport respectivement au poids total de la partie solide de la composition sensible au rayonnement.

5. Composition sensible au rayonnement selon une ou plusieurs des revendications 1 à 4, caractérisée en ce que le titre du ou des composés clivables par un acide s'élève à 1 à 50% en poids, de préférence à 10 à 40% en poids, par rapport respectivement au poids total des matières solides de la composition sensible au rayonnement.

6. Matériel d'enregistrement sensible au rayonnement travaillant en positif, constitué d'un support avec une couche sensible au rayonnement, caractérisé en ce que la couche est constituée d'une composition selon une ou plusieurs des revendications 1 à 5.
